Europäisches Patentamt

European Patent Office

Office européen des brevets

(11) Numéro de publication: **0 130 129**
**B1**

(12) **FASCICULE DE BREVET EUROPEEN**

(51) Int. Cl.⁴: **G 11 C 17/00**

(45) Date de publication du fascicule du brevet:
**01.06.88**

(21) Numéro de dépôt: **84401331.8**

(22) Date de dépôt: **26.06.84**

(54) **Mémoire permanente organisée en deux demi-plans pour améliorer la vitesse de lecture.**

(30) Priorité: **28.06.83 FR 8310680**

(43) Date de publication de la demande:
**02.01.85 Bulletin 85/1**

(45) Mention de la délivrance du brevet:
**01.06.88 Bulletin 88/22**

(84) Etats contractants désignés:
**DE FR GB IT NL**

56 Documents cités:
**FR - A - 2 410 337**

**PATENTS ABSTRACTS OF JAPAN, vol. 2, no. 75, 14 juin 1978, page 3002 E 78; & JP-A- 53 41 141 (NIPPON DENKI K.K.) (14.04.1978)**
**PATENTS ABSTRACTS OF JAPAN, vol. 5, no. 60, page 125 P 58, 23 avril 1981; & JP-A- 56 13 593 (OKI DENKI K.K.) (09.02.1981)**

73 Titulaire: **SGS-THOMSON MICROELECTRONICS S.A., 101, bld Murat, F-75016 Paris (FR)**

72 Inventeur: **Kritter, Sylvain, THOMSON-CSF SCPI 173, bld Haussmann, F-75379 Paris Cedex 08 (FR)**
Inventeur: **Vellou, Daniel, THOMSON-CSF SCPI 173, bld Haussmann, F-75379 Paris Cedex 08 (FR)**

74 Mandataire: **Guérin, Michel et al, THOMSON-CSF SCPI 19, avenue de Messine, F-75008 Paris (FR)**

ACTORUM AG

## Description

La présente invention concerne les mémoires permanentes, éventuellement reprogrammables électriquement, telles que les mémoires à transistors MOS à grille flottante ou à transistors MNOS (Metal-Nitrure-Oxyde-Semiconducteur).

Plus généralement elle concerne les mémoires non volatiles dont les points-mémoire individuels sont des éléments qui présentent, vus à partir d'un conducteur de colonne reliant tous les points d'une colonne de points-mémoire, une certaine impédance capacitive; cette impédance capacitive, qui est multipliée par le nombre d'éléments de la colonne, tous en parallèle entre le conducteur de colonne et la masse, est suffisamment importante dans certains cas pour qu'on désire l'utiliser lors de la lecture de l'état des points-mémoire de la colonne.

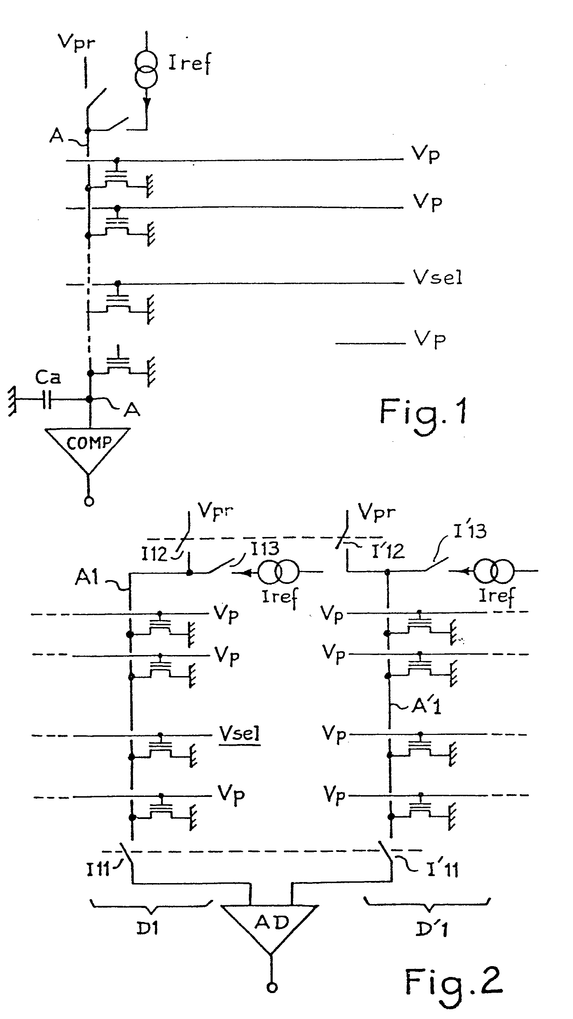

La figure 1 représente schématiquement un mode de lecture de l'état d'un point-mémoire d'une colonne (une seule colonne, celle qui est sélectionnée dans la mémoire, a été représentée). Chaque point mémoire est un transistor MNOS (par exemple) dont la source est reliée à la masse, le drain à un conducteur de colonne A commun aux transistors de la colonne, et la grille à un conducteur de ligne respectif pour chaque transistor de la colonne. L'état binaire d'un point-mémoire dépend des charges stockées dans le transistor.

On a représenté une capacité Ca entre le conducteur de colonne A et la masse. Cette capacité est fictive et représente la somme des capacités des points-mémoire de la colonne vus entre le conducteur de colonne et la masse.

La sélection d'un point-mémoire déterminé de la colonne se fait en appliquant une tension de polarisation Vsel sur la ligne correspondant à ce point et une tension de protection Vp aux autres lignes. Par exemple, la tension de polarisation rend le transistor conducteur ou le laisse bloqué selon l'état binaire du point mémoire (en pratique selon les charges stockées à l'inter face oxyde-nitrure du transistor MNOS) tandis que la tension de protection le maintient bloqué de toutes façons.

La lecture se fait de la manière suivante: une tension de précharge Vpr est appliquée dans une première phase à la colonne sélectionnée. Cette tension charge progressivement la capacité fictive Ca. A la fin du temps de précharge la tension Va sur le conducteur de colonne A atteint une tension V'pr qui est une fraction de la tension de précharge appliquée

$$V'pr = Vpr(1 - e^{-tpr/RaCa})$$

où tpr est le temps de précharge et RaCa la constante de temps de charge dépendant des impédances du circuit de précharge et de la colonne de points-mémoire.

Après la précharge, dans une deuxième phase, on supprime l'application de la tension de précharge, et on applique un courant de charge Iref au conducteur de colonne. En même temps, dans cette deuxième phase, on applique la tension de sélection Vsel à la ligne correspondant au point-mémoire sélectionné.

Si le transistor correspondant à ce point reste bloqué, le courant de charge Iref fera augmenter la tension Va du conducteur de colonne, en continuant à charger la capacité Ca. Si le transistor est conducteur, la capacité Ca se déchargera à travers ce transistor et le courant Iref sera insuffisant pour le charger ou le maintenir à sa charge première.

La lecture consiste alors, dans cette deuxième phase, à observer à l'aide d'un comparateur COMP (amplificateur à seuil par exemple) l'état de la tension Va sur le conducteur de colonne à la fin de la deuxième phase. Si elle est plus élevée que V'pr, c'est que le transistor était bloqué, si elle est plus faible, c'est que le transistor était conducteur. La sortie du comparateur bascule donc dans un sens ou dans l'autre selon l'état du point-mémoire sélectionné.

Les problèmes que l'on peut rencontrer sont les suivants:
- le point-mémoire doit avoir une taille aussi petite que possible; il en résulte notamment que le courant de décharge de la capacité, lorsque le transistor est conducteur, restera faible;
- Iref doit être plus petit que ce courant de décharge compte tenu du mode de lecture expliqué ci-dessus; d'ailleurs il est souhaitable que ces deux courants soient faibles, pour des raisons de réduction de la consommation de la mémoire;
- ceci implique une charge et une décharge lente de la capacité Ca;
- mais on voudrait que la lecture se fasse aussi rapidement que possible malgré les deux phases nécessaires (précharge et lecture proprement dite);
- par conséquent, d'une part l'amplificateur devrait avoir un grand gain (pour détecter rapidement le sens de charge ou décharge de la capacité Ca), et d'autre part le seuil de basculement (tension de référence par rapport à laquelle on veut détecter le sens de variation de charge de Ca) doit être très précis et aussi proche que possible de V'pr c'est à dire de la tension normalement atteinte aux bornes de Ca à la fin de la précharge;
- avoir un grand gain d'amplificateur et une tension de référence précise nécessite des circuits sophistiqués, encombrants et consommant de la puissance, ou, si c'est la tension de précharge Vpr elle-même qui est utilisée comme référence, c'est le temps de précharge qui doit être allongé considérablement pour que V'pr se rapproche autant que possible de Vpr.

La présente invention propose une solution permettant de concilier ces différents aspects.

Dans une mémoire intégrée non-volatile, du type dans lequel les colonnes de points-mémoire présentent une capacité non négligeable utilisée pour mettre en évidence une variation de tension sur un conducteur de colonne sélectionnée, lorsqu'un courant de charge est appliqué à ce

conducteur, cette variationde tension étant liée à l'état du point-mémoire sélectionné, et le conducteur de colonne étant susceptible d'être relié à une entrée d'un amplificateur différentiel dont l'autre entrée reçoit une tension de comparaison, l'invention propose:

– d'organiser la mémoire en deux demi-plans, la sélection d'une colonne de points-mémoire désignant à la fois une colonne de points-mémoire dans l'un des demi-plans et une colonne de points-mémoire dans l'autre demi-plan, et la sélection d'une ligne désignant au contraire une ligne soit dans l'un, soit dans l'autre des demi-plans mais non dans les deux à la fois;

– d'appliquer les colonnes désignées, lors de la lecture, chacune à une entrée de l'amplificateur différentiel, la tension sur le conducteur de colonne désignée du demi-plan dans lequel aucune ligne n'est sélectionnée constituant la tension de comparaison à laquelle on compare la tension sur le conducteur de colonne désignée du demi-plan dans lequel une ligne est désignée, un courant de charge étant appliqué à cette dernière colonne.

En principe, pour chaque colonne sélectionnée du premier demi-plan, une colonne différente respective est sélectionnée dans l'autre demi-plan; ces deux colonnes auront alors la même adresse de colonne.

Pour un mode de lecture en deux phases, précharge et lecture proprement dite, on prévoit alors que, dans la phase de précharge, une tension de précharge identique est appliquée aux deux colonnes sélectionnées (une dans chaque demi-plan), puis, dans la phase de lecture, la tension de précharge n'étant plus appliquée, une tension de sélection de ligne est appliquée à une ligne d'un seul demi-plan (celui qui contient le point-mémoire à lire), et un courant de charge (Iref) est appliqué au conducteur de colonne sélectionnée de ce demi-plan.

Grâce à l'invention, on réalise donc une tension de comparaison essentiellement variable mais qui est justement la tension à laquelle se charge une colonne de points-mémoire. A la dispersion près des caractéristiques du circuit intégré, la capacité de charge Ca est sensiblement la même pour toutes les colonnes, de sorte que pendant la phase de précharge, en appliquant la tension de précharge Vpr à une colonne qui ne contient pas le point-mémoire sélectionné, on établit sur l'une des entrées de l'amplificateur différentiel une tension de comparaison qui a toutes les qualités requises puisqu'elle atteint la valeur V'pr par rapport à laquelle on voudra détecter le sens de variation de tension de la colonne active qui contient le point-mémoire sélectionné.

Il sera donc inutile de prévoir une tension de référence (seuil d'amplificateur) précise. De plus, si l'amplificateur a un gain suffisant, la lecture pourra être très rapide car la sortie de l'amplificateur basculera très rapidement dans un sens ou dans l'autre.

Cette structure de mémoire ne nécessite pas d'augmentation de surface de circuit car la colonne servant de référence est une colonne de la mémoire elle-même et non une colonne supplémentaire inutile uniquement réservée à cet usage.

Les rôles des colonnes sont parfaitement interchangeables, une colonne d'un demi-plan quelconque pouvant être une colonne active lorsqu'on lit un point-mémoire dans cette colonne, ou une colonne de référence lorsqu'on lit un point-mémoire dans une colonne correspondante de l'autre demi-plan.

Le décodage pour l'accès aux différents points-mémoire est légèrement modifié, et le décodeur de sélection de ligne devra à la fois commander l'application d'une tension de sélection de ligne, et déterminer celui des demi-plans auquel il faut appliquer le courant de charge durant la phase de lecture proprement dite.

D'autres caractéristiques et avantages de l'invention apparaîtront à la lecture de la description détaillée qui suit et qui est faite en référence aux dessins annexés dans lesquels:

la fig. 1 déjà décrite représente un système de lecture normal, avec précharge, de l'état d'un point-mémoire d'une colonne présentant une impédance capacitive non négligeable;

la fig. 2 représente le principe de lecture différentielle adopté selon l'invention;

la fig. 3 représente l'organisation générale de la mémoire selon l'invention.

A la figure 2, on a représenté un amplificateur différentiel AD dont la sortie fournit le résultat binaire 0 ou 1 de la lecture de l'état d'un point-mémoire sélectionné d'une colonne sélectionnée faisant partie d'un demi-plan donné de la mémoire.

Seule cette colonne sélectionnée, D1, a été représentée, avec la colonne correspondante, D'1, sélectionnée en même temps, de l'autre demi-plan de la mémoire selon l'invention. Les points-mémoire sont des transistors MNOS par exemple, montés comme expliqué en référence à la figure 1.

La sélection des colonnes D1 et D'1 se fait en reliant le conducteur de colonne A1 (qui réunit les drains des transistors de la colonne D1) à une entrée de l'amplificateur différentiel, et le conducteur de colonne A'1 (qui réunit les drains des transistors de la colonne D'1) à l'autre entrée; des interrupteurs I11 et I'11, commandés par un décodeur de colonne recevant à cet effet l'adresse en colonne du point-mémoire sélectionné, sont prévus pour effectuer ces connexions.

La sélection des colonnes D1 et D'1 se fait aussi, pendant la phase de précharge en appliquant par des interrupteurs I12 et I'12 une tension de précharge commune Vpr respectivement aux conducteurs D1 et D'1; la fermeture des interrupteurs I12 et I'12 est également commandée par le décodeur de colonne.

La sélection en ligne se fait comme expliqué en référence à la figure 1 d'abord par une tension de sélection Vsel appliquée sur les grilles réunies d'une ligne de points-mémoire, et une tension de protection Vp sur les autres lignes.

Ici, seule une ligne d'un demi-plan mémoire est sélectionnée (celui de gauche sur la figure); par conséquent, toutes les lignes de l'autre demi-plan sont protégées. C'est un décodeur de ligne, recevant l'adresse en ligne du point à lire, qui définit la ligne sélectionnée; un décodeur de demi-plan peut être prévu pour définir dans quel demi-plan est situé le point à lire; en fait on considérera par exemple que c'est le bit de poids fort de l'adresse en ligne qui définira ce demi-plan.

La tension de sélection est appliquée pendant la phase de lecture proprement dite, après la fin de la phase de précharge et après ouverture des interrupteurs I12 et I'12, ou bien légèrement avant. Pendant cette phase de lecture, l'un ou l'autre des deux interrupteurs I13 et I'13 est fermé pour appliquer un courant de charge Iref à celle des deux colonnes D1 et D'1 qui contient le point à lire (en l'occurence D1). Sur la figure, on a représenté deux sources Iref, mais il peut y avoir une source unique appliquée soit à l'une soit à l'autre des colonnes. En pratique, il y a une source de courant prévue pour chaque colonne. Le décodeur de colonne détermine l'adresse de colonne lue et le décodeur de demi-plan (ou un bit du décodeur de lignes) définit à laquelle des deux colonnes de même adresse doit être appliqué le courant de charge Iref, donc lequel des interrupteurs I13 ou I'13 doit être fermé.

A la fin de la phase de précharge, les entrées de l'amplificateur différentiel sont sensiblement équilibrées (tension V'pr sur les deux conducteurs de colonne A1 et A'1); au cours de la phase de lecture, un déséquilibre se produit très rapidement dans un sens ou l'autre selon l'état du point-mémoire sélectionné comme dans le cas de la figure 1, la tension restant sensiblement égale à V'pr sur le conducteur A'1 et la tension sur le conducteur A1 s'écartant de V'pr dans un sens ou dans l'autre selon que le transistor sélectionné par Vsel reste bloqué ou devient conducteur.

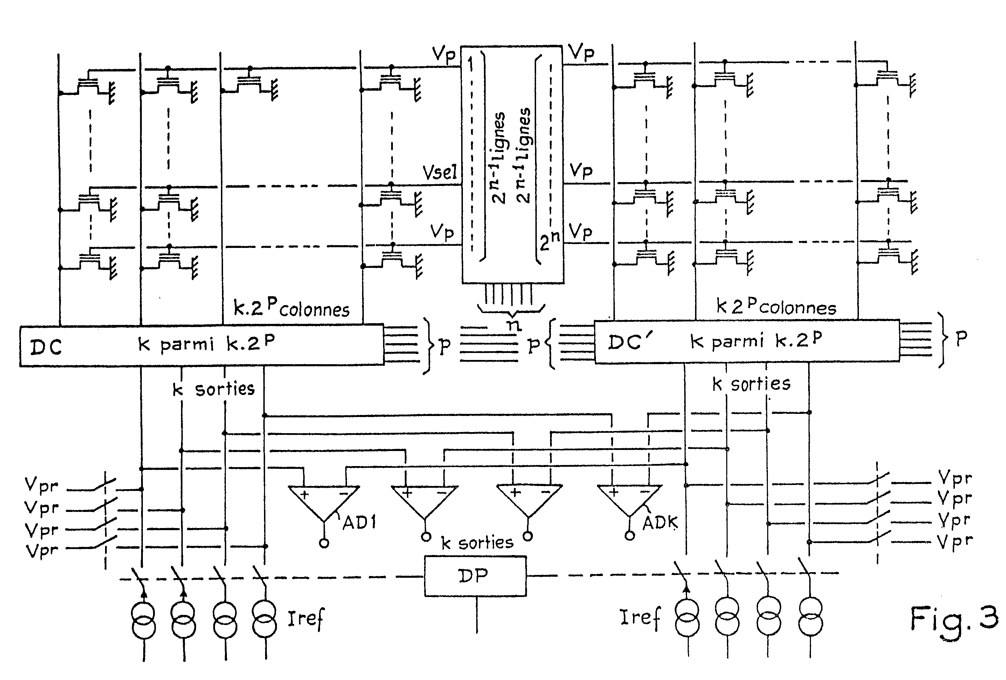

A la figure 3, on voit l'essentiel de l'organisation générale de la mémoire.

La mémoire est divisée en deux demi-plans, l'un comprenant $2^{n-1}$ lignes et $k.2^p$ colonnes, et l'autre comprenant aussi $2^{n-1}$ lignes et $k.2^p$ colonnes. Les $k.2^p$ colonnes de chaque demi-plan sont divisées en groupes de k bits, la mémoire fournissant des mots de k bits.

Dans ce cas, k amplificateurs opérationnels AD1 à ADk sont prévus.

Un décodeur de ligne DL désigne une ligne parmi $2^n$, grâce à une adresse de n bits, et cette ligne se situe soit dans le demi-plan de gauche, soit dans le demi-plan de droite.

Un décodeur de colonne désigne k colonnes parmi $k.2^p$ dans le demi-plan de gauche et k colonnes correspondantes parmi $k.2^p$ dans le demi-plan de droite, et ceci grâce à une adresse unique de p bits pour les deux demi-plans. On a représenté en fait sur la figure 3 deux modules de décodage de colonne DC et DC'.

Enfin un décodeur de demi-plan DP a été représenté, mais il peut correspondre seulement à un bit d'adresse de ligne, par exemple le bit de poids fort des n bits d'adresse de ligne.

Chaque amplificateur différentiel reçoit sur une entrée un conducteur issu des sorties du décodeur de colonne, et sur son autre entrée un conducteur issu également du décodeur de colonne mais correspondant à un conducteur de colonne de l'autre demi-plan (cf. interrupteurs I11 et I'11 de la figure 2). Les k amplificateurs reçoivent ainsi chacun une des k sorties du module de décodage DC et une des k sorties du module de décodage DC'.

Le décodeur de colonne DC, DC' est relié par ailleurs évidemment aux $k.2^p$ colonnes de points de chaque demi-plan puisqu'il a pour fonction de choisir, pour chaque adresse de colonne reçue, k colonnes de points-mémoire parmi $k.2^p$ dans chaque demi-plan.

Une source de tension de précharge Vpr peut être appliquée aux 2k colonnes sélectionnées (cf. interrupteurs I12, I'12 de la figure 2).

Enfin, les sources de courant de charge Iref ont été représentées comme étant au nombre de 2k et comme pouvant être reliées chacune à une entrée d'un amplificateur respectif parmi k, le choix de l'application de k sources aux entrées inverseuses ou des k autres sources aux entrées non inverseuses des amplificateurs pouvant être fait par le décodeur de demi-plan ou dans l'autre.

On notera qu'il est souhaitable, pour ne pas avoir de problème de sens de lecture de l'amplificateur différentiel selon qu'un mot est lu dans un demi-plan ou l'autre, de prévoir d'inscrire dans l'un des demi-plans des mots vrais que l'on souhaite lire, mais dans l'autre des mots sous forme complémentée.

**Revendications**

1. Mémoire permanente intégrée, du type dans lequel les colonnes de points-mémoire présentent une capacité équivalente non négligeable (Ca) utilisée pour définir une variation de tension sur une colonne sélectionnée lorsqu'un courant de charge (Iref) est appliqué à cette colonne, cette variation de tension étant différente selon l'état du point-mémoire sélectionné dans cette colonne, et la colonne étant reliée à une entrée d'un amplificateur différentiel dont l'autre entrée reçoit une tension de comparaison, caractérisée en ce que:

– la mémoire est organisée en deux demi-plans, la sélection d'une colonne de points-mémoire désignant en réalité à la fois une colonne (D1) de points-mémoire dans l'un des demi-plans et une colonne (D'1) de points-mémoire dans l'autre demi-plan, et la sélection d'une ligne désignant au contraire une ligne soit dans l'un, soit dans l'autre des demi-plans mais non dans les deux à la fois;

– les colonnes désignées sont appliquées, pour la lecture, chacune à une entrée de l'amplificateur différentiel, la tension sur la colonne désignée du demi-plan dans lequel aucune ligne n'est sélectionnée constituant la tension de comparaison à laquelle dans lequel une ligne est sélectionnée, un courant de charge étant appliqué à cette dernière colonne.

2. Mémoire permanente intégrée, caractérisée en ce que pour chaque colonne sélectionnée du premier demi-plan, une colonne différente respective est sélectionnée du premier demi-plan, une colonne différente respective est sélectionnée dans l'autre demi-plan.

3. Mémoire permanente intégrée, selon l'une des revendications 1 et 2, caractérisée en ce que la lecture d'un point mémoire consiste à appliquer une tension de précharge (Vpr) identique aux deux colonnes sélectionnées, puis un courant de charge (Iref) à la colonne sélectionnée du demi-plan dans lequel une ligne est sélectionnée.

## Patentansprüche

1. Integrierter Festwertspeicher, in dem die Spalten von Speicherpunkten eine nicht vernachlässigbare äquivalente Kapazität (Ca) darstellen, die zur Definition einer Spannungsveränderung auf einer ausgewählten Spalte verwendet wird, wenn ein Laststrom (Iref) an diese Spalte angelegt wird, wobei diese Spannungsänderung vom Zustand des in dieser Spalte ausgewählten Speicherpunkts abhängt und die Spalte an einen Eingang eines Differentialverstärkers angelegt ist, dessen anderer Eingang eine Vergleichsspannung zugeführt erhält, dadurch gekennzeichnet, dass
- der Speicher in zwei Halbebenen organisiert ist, wobei die Auswahl einer Spalte von Speicherpunkten in Wirklichkeit sowohl eine Spalte (D1) von Speicherpunkten in einer der Halbebenen und eine Spalte (D'1) von Speicherpunkten in der anderen Halbebene bezeichnet, wogegen die Auswahl einer Zeile entweder in der einen oder in der anderen Halbebene, aber nicht in beiden zugleich, eine Zeile bestimmt;
- die bestimmten Spalten für den Lesevorgang je an einen Eingang des Differentialverstärkers angelegt werden, wobei die Spannung auf der bestimmten Spalte der Halbebene, in der keine Zeile ausgewählt ist, die Vergleichsspannung darstellt, mit der die Spannung an der bestimmten Spalte der Halbebene verglichen wird, in der eine Zeile ausgewählt ist, wobei ein Laststrom an diese letztere Spalte angelegt wird.

2. Integrierter Festwertspeicher, dadurch gekennzeichnet, dass für jede ausgewählte Spalte der ersten Halbebene eine jeweils andere Spalte in der anderen Halbebene ausgewählt wird.

3. Integrierter Festwertspeicher nach einem der Ansprüche 1 und 2, dadurch gekennzeichnet, dass zum Lesen eines Speicherpunkts eine gleiche Vor-Ladespannung (Vpr) an die beiden ausgewählten Spalten angelegt wird, und dass dann ein Laststrom (Iref) an die ausgewählte Spalte der Halbebene angelegt wird, in der eine Zeile ausgewählt ist.

## Claims

An integrated read-only memory of the type in which the columns of memory points present a non-negligeable equivalent capacity (Ca), which is used to define a voltage variation on a selected column when a charge current (Iref) is applied to this column, this voltage variation depending on the state of the selected memory point from this column, and the column being connected to one input of a differential amplifier, the other input of which receives a comparison voltage, characterized in that
- the memory is organized in two half-planes, the selection of a column of memory points defining in fact as well a column (D1) of memory points in one of the half-planes as a column (D'1) of memory points in the other half-plane, while the selection of a line defines a line either in one or in the other half-plane, but not simultaneously in both planes;
- the defined columns are applied for reading purposes each to one input of a differential amplifier, the voltage on the defined column of the half-plane in which no line at all is selected constituting the comparison voltage to which is compared the voltage in the defined column of the half-plane in which a line is selected, a charge current being applied to this latter column.

2. An integrated read-only memory, characterized in that for each selected column of the first half-plane, a different respective column is selected in the other half plane.

3. An integrated read-only memory according to one of claims 1 and 2, characterized in that the read-out of a memory point consists in applying identically a precharge voltage (Vpr) to both selected columns, and then a charge current (Iref) to the column of the half-plane in which a line is selected.

Fig.1

Fig.2

Fig. 3